Europäisches Patentamt

European Patent Office

Office européen des brevets

(11) Publication number: 0 304 073
A2

# (12) EUROPEAN PATENT APPLICATION

(21) Application number: 88113499.3

(22) Date of filing: 19.08.88

(51) Int. Cl.⁴: H01L 21/263 , H01L 21/283

(30) Priority: 21.08.87 JP 207540/87

(43) Date of publication of application:
22.02.89 Bulletin 89/08

(84) Designated Contracting States:
DE FR GB NL

(71) Applicant: KABUSHIKI KAISHA TOSHIBA
72, Horikawa-cho Saiwai-ku
Kawasaki-shi Kanagawa-ken 210(JP)

(72) Inventor: Shimada, Kizashi
c/o Patent Division K.K.Toshiba 1-1 Shibaura
1-chome Minato-ku Tokyo 105(JP)
Inventor: Akiyama, Tatsuo
c/o Patent Division K.K.Toshiba 1-1 Shibaura
1-chome Minato-ku Tokyo 105(JP)
Inventor: Koshino, Yutaka
c/o Patent Division K.K.Toshiba 1-1 Shibaura
1-chome Minato-ku Tokyo 105(JP)

(74) Representative: Ritter und Edler von Fischern,
Bernhard,Dipl.-Ing. et al
HOFFMANN - EITLE & PARTNER
Arabellastrasse 4
D-8000 München 81(DE)

(54) Method for manufacturing semiconductor device with schottky electrodes.

(57) A method for manufacturing a semiconductor device with a Schottky electrode comprises the steps of subjecting the surface of a GaAs substrate (10) to a spattering etching process in a spattering processing chamber (1) of a spattering device; and depositing Schottky electrode material by spattering on the surface of the substrate (1) to form a Schottky electrode in the processing chamber (1) without exposing the substrate (10) to the atmosphere.

FIG. 1

## Method for manufacturing semiconductor device with Schottky electrodes

This invention relates to a method for manufacturing semiconductor devices, and more particularly to a method for manufacturing a Schottky electrode on the surface of a GaAs (gallium arsenide) semiconductor substrate.

In a case where Schottky electrode material of Schottky diodes or metal semiconductor field effect transistors (MESFETs) is deposited on the GaAs substrate by a spattering method or vapor deposition method, a pre-processing is effected to remove the natural oxide film on the surface of the semiconductor substrate. A wet-etching process or $NH_3$ (ammonium) plasma process is effected as the pre-processing, for example. The wet-etching process is effected by chemically cleaning the semiconductor substrate using ammonium fluoride ($NH_4F$), dilute hydrofluoride acid (HF), hydrochloric acid (HCl) or the like. However, in this case, it is impossible to completely eliminate the natural oxide film on the surface of the GaAs substrate. Further, as disclosed in papers pp. 18 to 23 (Shimada et al.) of "27th SEMICONDUCTOR INTEGRATED CIRCUIT SYMPOSIUM", the natural oxide film on the surface of the GaAs substrate can be completely removed by use of the $NH_3$ plasma processing. In this case, however, if the GaAs substrate is exposed to the atmosphere after the completion of the $NH_3$ plasma processing and before the Schottky electrode material is deposited on the substrate, the natural oxide film may be formed again on the surface of the substrate. As a result, a Schottky electrode will be formed on the natural oxide film. In this way, if the natural oxide film is formed between the Schottky electrode and the GaAs substrate, desired Schottky junction cannot be attained. Therefore, the Schottky characteristics may fluctuate, so that the n value (environmental factor) may be increased and/or $\phi_B$ (barrier height) may be decreased.

As described above, the conventional method has a problem that since the surface of the substrate is exposed to the atmosphere after the natural oxide film on the GaAs substrate is removed by the plasma processing and before the Schottky electrode is formed on the substrate, desired Schottky junction cannot be obtained.

An object of this invention is to provide a method for manufacturing semiconductor devices in which a Schottky electrode can be formed without forming a natural oxide film between the Schottky electrode and the GaAs substrate, thus attaining desired Schottky junction.

The above object can be attained by a method for manufacturing a semiconductor device with a Schottky electrode, comprising the steps of (a) subjecting the surface of a GaAs substrate to a spattering etching process in a spattering processing chamber of a spattering device, and (b) depositing Schottky electrode material by spattering on the surface of the substrate to form a Schottky electrode in the same processing chamber without exposing the substrate to an atmosphere.

In this invention, since the spattering etching step and the spattering deposition step are successively effected in the vaccum chamber, the Schottky electrode can be formed directly on the surface of the GaAs substrate without forming the natural oxide film thereon, and a semiconductor device such as a MESFET and Schottky diode having desired Schottky junction can be obtained.

This invention can be more fully understood from the following detailed description when taken in conjunction with the accompanying drawings, in which:

Fig. 1 is a diagram schematically showing an example of a spattering device which is used to effect a semiconductor device manufacturing method according to one embodiment of this invention; and

Figs. 2A to 2E are cross sectional views showing the manufacturing steps of the semiconductor device according to one embodiment of this invention.

There will now be described a semiconductor device manufacturing method according to one embodiment of this invention.

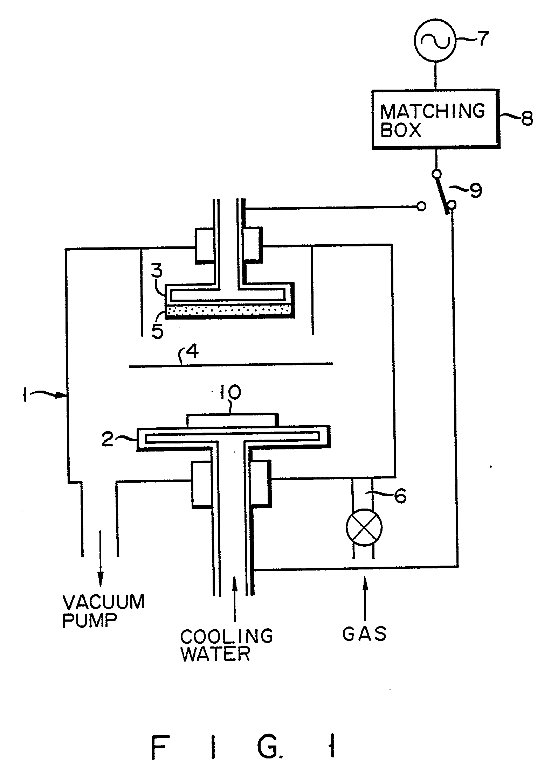

Fig. 1 schematically shows the construction of an example of a spattering device which is used to effect a semiconductor device manufacturing method according to one embodiment of this invention. The spattering device includes spattering processing chamber 1 which is kept in a predetermined vaccum condition by a vaccum pump (not shown). In processing chamber 1, lower electrode 2 and upper electrode 3 are disposed in opposition to and in parallel with each other, and shutter 4 which can be used to shield upper electrode 3 from the outer atmosphere is movably mounted below upper electrode 3. GaAs substrate 10 to be spattered, as described later, is held on lower electrode 2 by means of a holder (not shown), and target 5 formed of, for example, WSi (tungsten silicide) is held on the lower surface of upper electrode 3. Lower electrode 2 is formed with a hollow portion to receive cooling water from processing chamber 1, and gas inlet port 6 is provided on processing chamber 1. A gas supply source (not shown) is arranged outside processing chamber 1. An inert gas such as Ar can be used therefor. Further, switch 9 which selectively supplies high frequency power (for example, 13.56 MHz) from high frequency power source 7 to lower electrode 2 or upper electrode 3 via impedance matching box 8 is provided outside processing chamber 1.

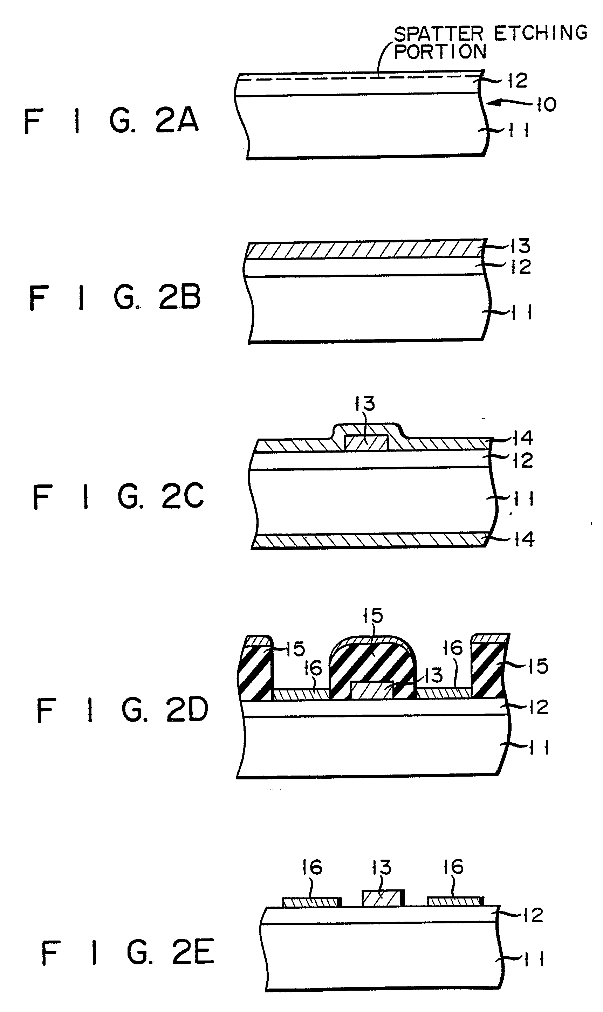

Next, an example of the method for manufacturing the semiconductor device is explained with reference to Figs. 2A to 2E. First, as shown in Fig. 2A, silicon ion ($Si^+$) is ion-implanted into GaAs substrate 11 having main plane of the Miller indices (100) in a condition that an acceleration voltage is set at 150 keV and dose amount is set at $2.5 \times 10^{12}$ cm$^{-2}$. After this, substrate 11 is subjected to heat treatment for 15 minutes at 820°C in an atmosphere or arsine ($AsH_3$) so as to anneal the doped silicon ion. As a result, n-type impurity region 12 of low impurity concentration is formed in the surface of substrate 11. The n-type GaAs substrate thus obtained is chemically cleaned by use of $NH_4F$ (ammonium fluoride) to remove the natural oxide film on the surface, although insufficiently. Then, GaAs substrate 10 is set in spattering processing chamber 1, and the pressure in processing chamber 1 is lowered to $1 \times 10^{-4}$ Pa. After this, Ar (argon) gas is introduced as etchant gas into processing chamber 1 until the inner pressure reaches approx. 0.8 Pa. Then, high frequency power of approx. 1 kW is applied to lower electrode 2 in order to effect spattering etching process for the substrate surface of about 5 minutes. As a result of this, the substrate surface layer is partially removed as shown by broken lines in Fig. 2A. In this case, in order to prevent target 5 from being contaminated, shutter 4 is previously closed.

Next, $N_2$ (nitrogen) gas is introduced into processing chamber 1 to provide a partial pressure equal to 10% of the total gas pressure in processing chamber 1, thus creating an atmosphere of ($Ar + N_2$). Then, high frequency power is applied to upper electrode 3 and shutter 4 is opened so as to effect the reactive spattering process. This operation is effected until a nitride film of tungsten silicide or WSi-Nx film 13 is deposited to a thickness of approx. 150 nm on the substrate surface as shown in Fig. 2B. In this case, processing chamber 1 is held in substantially vaccum condition while a process, from the step of spattering-etching the substrate surface to the step of spattering-depositing the substrate surface, is effected. In this way, since the substrate surface is not exposed to the atmosphere, the natural oxide film will not be formed between WSi-Nx film 13 and the substrate surface, permitting WSi-Nx film 13 to be formed directly on the substrate surface.

After this, the Schottky electrode of a Schottky diode of MESFET is formed according to the ordinary process. That is, a photoresist pattern with a 1 mm diameter corresponding to the size of the Schottky electrode is formed on WSi-Nx film 13 by a photolithographic process, and then WSi-Nx film 13 is patterned by a reactive ion etching method (RIE) or chemical dry etching method (CDE) with the photoresist pattern used as a mask as shown in Fig. 2C. Then, PSG (phosphor silicate glass) films 14 are formed as insulation coating films to a thickness of approx. 400 nm on both surfaces of the substrate, and a heat treatment is effected for 10 minutes at a temperature of about 800°C in order to restore the damage caused in the substrate spattering process. After this, in order to form an ohmic electrode, PSG film 14 is etched out, resist pattern 15 is formed as shown in Fig. 2D, and a two-layered ohmic electrode layer such as Ni/AuGe film 16 having a lower layer of AuGe (gol germanium) and an upper layer of Ni (nickel), for example, is formed. Then, resist pattern 15 is removed, and a heat treatment is effected at a temperature of 430°C in $N_2$ gas for three minutes to form an alloy. As a result, a GaAs Schottky diode having Schottky electrode 13 and ohmic electrode 16 is obtained as shown in Fig. 2E.

The Schottky diode formed to have the Schottky electrode is completed as a discrete part after being subjected to the succeeding manufacturing steps.

Further, in order to lower the resistance of that part of n-type low impurity concentration layer 12 which lies in the substrate surface under ohmic electrode 16, it is possible to dope impurity into the part to form an n-type high impurity concentration region.

In the above embodiment, WSi is used as target material, but it is not limited to WSi. For example, other refractory metal such as W, WNx, Ti can be used, and in this case, inert gas used in the spattering deposition process will be selected according to the type of refractory metal used.

According to the manufacturing method of the above embodiment, since the spattering etching step and the spattering deposition step are successively effected in the vaccum chamber, the Schottky electrode can be formed directly on the GaAs substrate surface without forming the natural oxide film therebetween and MESFETs and Schottky diodes having desired Schottky junction can be obtained. The characteristics of the Schottky diode manufactured according to the above embodiment can be improved over those of the Schottky diode manufacturing without effecting the spattering etching process, as shown in the following table. In the following table, the average values of the diode characteristics measured at selected five points in the semiconductor wafer are shown.

Table 1

| Schottky electrode material | substrate etching | n Value | | leak current (nA) when reverse bias ($V_R = -10V$) is applied |
|---|---|---|---|---|
| $WSi_{0.6}$-N | no | 1.07 | 0.771 | -67 |
| $WSi_{0.6}$-N | no | 1.06 | 0.798 | -16 |

In the above table, composition ratio of W and Si in Schottky electrode material WSi-N is 1 : 0.6. In this example, there occurs no damage due to etching, and n value (environmental factor) and $\phi_B$ (barrier height) are not deteriorated, and the leak current occurring when the reverse bias voltage ($V_R$) is applied is suppressed to a minimum.

As described above, according to the semiconductor device manufacturing method of this invention, a semiconductor device can be manufactured in which the Schottky electrode can be formed by deposition on the GaAs substrate without forming the natural oxide film therebetween and thus desired Schottky characteristics can be obtained.

## Claims

1. A method for manufacturing a semiconductor device with a Schottky electrode comprising the steps of:

subjecting the surface of a GaAs substrate (10) to a spattering etching process in a spattering processing chamber (1) of a spattering device, and

depositing Schottky electrode material by spattering on the surface of said substrate (1) to form a Schottky electrode (13) in said processing chamber (1) without exposing said substrate (10) to the atmosphere.

2. A method according to claim 1, characterized in that said GaAs substrate (10) is chemically cleaned before said spattering etching step.

3. A method according to claim 1, characterized in that said spattering etching and spattering deposition steps are effected in an inert gas atmosphere, with said substrate (10) and a refractory metal respectively used as targets.

4. A method according to claim 1, characterized in that said spattering etching step is effected in an Ar atmosphere and said spattering deposition step is effected in an ($Ar + N_2$) atmosphere with WSi used as a target.

5. A method of manufacturing a semiconductor device comprising the steps of:

setting a GaAs substrate (11) having a main plane at a predetermined location in a spattering processing chamber (1);

ion-implanting silicon ions ($Si^+$) into the main plane of said GaAs substrate (11);

annealing said GaAs substrate (11) to form an n-type impurity region (12) on the main plane of said GaAs substrate (11);

chemically-cleaning said GaAs substrate (11) to remove an oxide film unintentionally formed on the main plane of said GaAs substrate (11);

effecting spattering etching on said GaAs substrate (11) in an atmosphere of an inert gas (Ar), so that a surface of the main plane of said GaAs substrate (11) is partially removed; and

effecting reactive spattering on the main plane of said GaAs substrate (11) in a given atmosphere to form a silicide film (WSi-Nx) on the main plane of said GaAs substrate (11).

6. A method according to claim 5, characterized in that the main plane of said GaAs substrate (11) is defined by Miller indices [100].

7. A method according to claim 5, characterized in that said annealing step is performed in an atmosphere of an $AsH_3$ gas.

8. A method according to claim 5, characterized in that said chemically-cleaning step is performed by use of $NH_4F$.

9. A method according to claim 5, characterized in that said spattering etching step is performed in an atmosphere of an inert gas (Ar).

10. A method according to claim 9, characterized in that said inert gas includes Ar.

11. A method according to claim 9, characterized in that said reactive spattering step is performed in an atmosphere of an $N_2$ gas and said innert gas (Ar) to form a nitride film (13) of a metal silicide (WSi-Nx) on the main plane of said GaAs substrate (11).

F I G. 1

VACUUM
PUMP

COOLING
WATER

GAS

MATCHING
BOX

SPATTER ETCHING
PORTION

F I G. 2A

— 12
— 10
— 11

F I G. 2B

— 13
— 12
— 11

13

F I G. 2C

— 14
— 12
— 11
— 14

15

F I G. 2D

15
16
16
15
13
— 12
— 11

16    13    16

F I G. 2E

— 12
— 11